# EUROPEAN PATENT APPLICATION

(11) **EP 1 986 477 A2**
(43) Date of publication of application: **29.10.2008**
(21) Application number: 07023051.1
(22) Date of filing: 28.11.2007
(51) Int. Cl.: H05K 1/02, H05K 1/16, H01P 3/08, H01P 11/00

(54) **Connecting structure in mobile terminal RF circuits and antennas**

(30) Priority: 24.04.2007 CN 200720108455 U
(71) Applicant: Ningbo Sagem Bird Research and Development Co. Ltd, Fenghua City 315500 Zhejiang (CN)
(72) Inventor: Brice, Pinta, No. 999 Dacheng East Road Fenghua City 315500 Zhejiang Province (CN)
(74) Representative: Maillet, Alain

(57) **Abstract**

The present invention relates to a connecting structure for connecting the RF circuits and the antenna of a mobile terminal which comprises a PCB (4) with said RF circuits and said antenna (2) being printed on an FPC board (5).

According to the invention, said connecting structure includes an RF strip-line (1) made from said FPC board, an end of the strip-line being feed-linked with the PCB with said RF circuits (4) and the other end being feed-linked to said antenna (2).

## Description

The present invention relates to a type of circuits connecting structure, especially for mobile terminal RF circuits and antennas.

As mobile phones are in increasingly wide use nowadays, their function, exterior design and cost have become the main competitive focus in the mobile terminal market. All mobile terminal-related business units are working hard on means to lower costs and reduce the size of various components.

At present, in most mobile terminal designs, the printed circuit board (PCB), which contains the radio frequency (RF) circuits, and the screen are placed in the upper half or a mobile terminal, while the battery and the flexible printed circuit (FPC) board, which includes the keyboard circuits, are placed in the bottom half. Because of the mobile terminal antenna's performance and radiation, it is typically placed at the bottom of the mobile terminal.

The bottom antenna and the upper RF circuits are connected by an RF coaxial line. However, this design has the following problems: first, it requires expensive RF coaxial line and four corresponding coaxial connectors.

For mobile terminal manufacturers, the component cost is very high. Second, this design requires placing a small piece of PCB as a connection between the antenna and the RF coaxial line. This not only makes manufacturing antennas more complex, but also adds processing costs for mobile terminal manufacturers.

To address these existing technical problems, the present invention provides a simple and cost-saving connecting structure for mobile terminal RF circuits and the antenna.

The technical features the present invention adopts to solve these technical problems is according to the appended claim 1. More particularly, the present invention concerns a connecting structure for connecting a RF circuit and an antenna of a mobile terminal which comprises a PCB with said RF circuits and said antenna being printed on an FPC board. It is characterized in that it includes an RF strip-line made from said FPC board, an end of the strip-line being feed-linked with the PCB with said RF circuits and the other end being feed-linked to said antenna.

In this connecting structure, the RF strip line contains an upper ground layer, middle ground layers, a signal transmission line which is in the same horizontal orientation as the middle ground layers on the cross section, a lower ground layer and a filling medium. The distance between the middle ground layer and upper ground layer is 95 microns and the distance between the middle ground layers and lower ground layer is also 95 microns. The signal transmission line section is a rectangle with an upper and lower width of 95 microns and a height of 32 microns, and the distance from the signal transmission line to the left and right middle ground layers is 200 microns, while the relative dielectric constant of the filing medium is 3.4.

In this connecting structure, the RF strip-line and the keyboard circuits of the mobile terminal are printed on the same FPC board.

The antenna in this connecting structure is the traditional FPC monopole antenna. It can be printed on the same FPC board with the keyboard circuits of the mobile terminal.

In this connecting structure, the matching component of the antenna is the traditional thin-film 0402 model inductor or capacitor. It can be printed on the same FPC board with the keyboard circuits of the mobile terminal.

In this connecting structure, the matching component of the antenna is the traditional thin-film 0402 model inductor or capacitor. It can be printed on the same FPC board with the keyboard circuits of the mobile terminal.

Compared to existing technologies, the present invention has the following advantages: in this connecting structure, the RF strip-line substitutes for the traditional expensive RF coaxial line and four corresponding coaxial connectors to connect the RF circuits and the antenna. Therefore the component cost of the mobile terminal is significantly reduced.

Since the RF strip-line and the antenna are connected by the traditional 0402 model inductor or capacitor, it is not necessary to rebuild a small piece of PCB to connect the antenna and the RF coaxial line. In addition, this connecting structure and the mobile terminal keyboard circuits can be printed on the same FPC board. All these not only reduce the manufacturing complexity of the antenna, but also significantly lower the manufacturing costs.

The characteristics of the invention will emerge more clearly from a reading of the following description of an example embodiment, the said description being produced with reference to the accompanying drawings, among which :
Fig. 1 shows the overall structure of the mobile terminal, with an example embodiment of this utility model.
Fig. 2 is an illustration of the RF strip-line in Fig. 1.
Fig. 3 shows the cross-section of the RF strip-line in Fig. 1.
Through the attached example embodiment figures, the present invention is described in further details as follows:

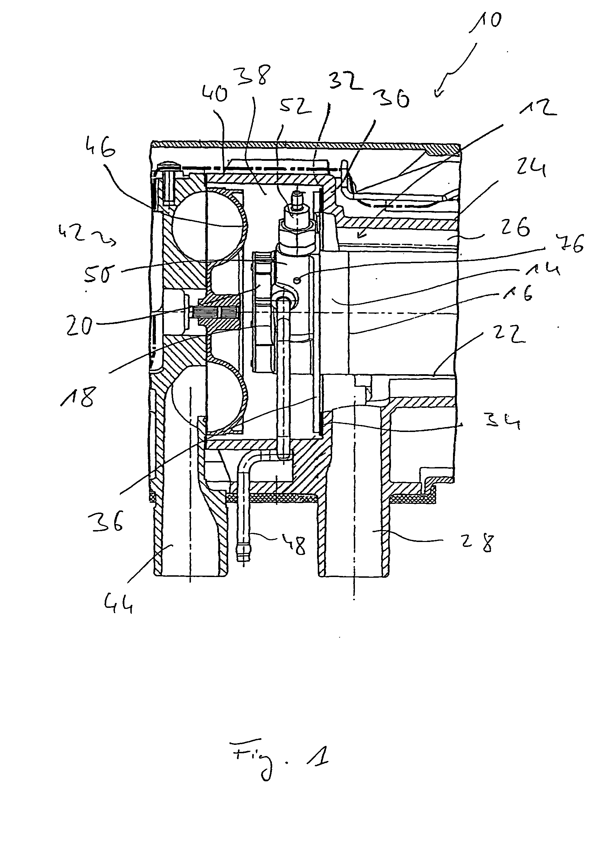

Figs. 1, 2 and 3 represents example embodiments of the present invention.

The RF strip-line 1, the antenna 2 and the matching component of the antenna 3 are integrated on the FPC keyboard circuits 5 of the mobile terminal, i.e., the RF strip-line 1, the antenna 2, the matching component of the antenna 3 and the FPC keyboard circuits of the mobile terminal are printed on the same FPC board. The antenna 2 is the traditional FPC monopole antenna. The matching component 3 is a traditional thin-film 0402 model inductor or capacitor, which is mounted between the RF strip-line 1 and the RPC antenna 2 by a mounting machine. The RF strip-line 1 and the PCB 4 with the RF circuits are connected by the FPC connector 7. The PCB 4 containing the RF circuits is placed in the upper half of the mobile terminal, very close to the mobile terminal screen. The FPC keyboard 5 is placed in the lower half the mobile terminal, very close to the mobile terminal battery. The keyboard signal line 6 of the mobile terminal and the PCB 4 containing the RF circuits are connected by the FPC connector 7.

In this connecting structure, the RF strip-line 1 contains the upper ground layer 11, the middle ground layer 12, the signal transmission line 13 (which is in the same horizontal direction as the middle ground layer on the cross section), the lower ground layer 14, and the filing medium 15.

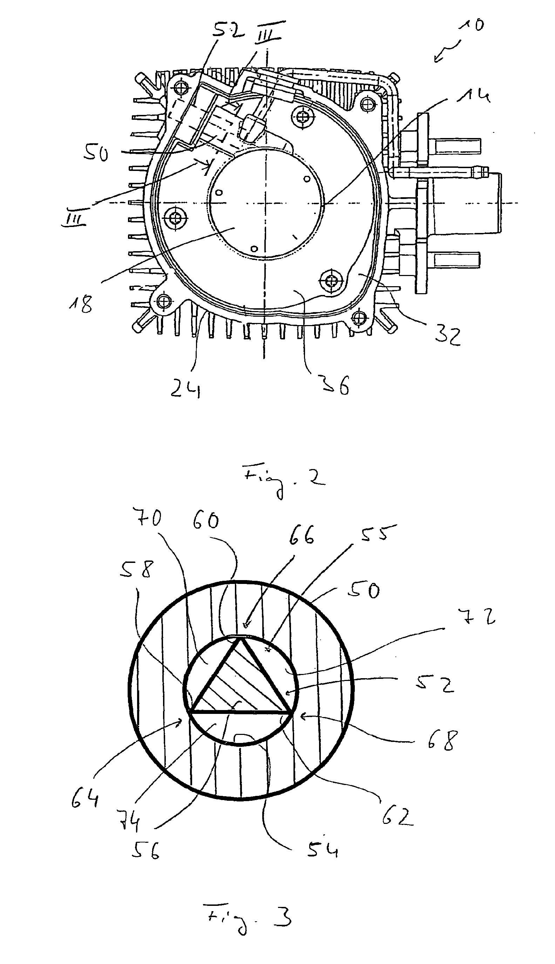

To ensure the characteristic impedance of the RF strip-line remains 50 ohms and to comply with the FPC manufacturing process and the actual testing, the distance H2 between the middle ground layer 12 and the upper ground layer 11 is 95 microns (see Fig. 3) ; the distance H1 between the middle ground layer 12 and the lower ground layer 14 is also 95 microns ; the cross-section of the signal transmission line 13 is a rectangle with both upper width W1 and lower width W2 of 95 microns and height T1 of 32 microns; the distance D1 from the signal transmission line 13 to the left and right middle ground layers 12 is 200 microns; and the relative dielectric constant of the filing medium 15 is 3.4.

## Claims

1. A connecting structure for connecting the RF circuits and the antenna of a mobile terminal which comprises a PCB (4) with said RF circuits and said antenna (2) being printed on an FPC board (5), **characterized in that** said connecting structure includes an RF strip-line (1) made from said FPC board, an end of the strip-line being feed-linked with the PCB with said RF circuits (4) and the other end being feed-linked to said antenna (2).

2. The connecting structure as claimed in Claim 1, **characterized in that** the said antenna (2) and the keyboard circuits (5) of the mobile terminal are printed on the said FPC board (5).

3. The connecting structure as claimed in Claim 1 or 2, **characterized in that** the said RF strip-line (1) includes an upper ground layer (11), middle ground layers (12), a signal transmission line (13) extending in the same horizontal direction as the middle ground layer (12) on the cross-section, a lower ground layer (14), and a filing medium (15).

4. The connecting structure as claimed in Claim 3, **characterized in that** the distance between the middle ground layer (12) and upper ground layer (11) is around 95 microns, the distance between the middle ground layers (12) and lower ground layer (14) is also around 95 microns, the cross-section of the signal transmission line (13) is a rectangle with upper and lower widths of around 95 microns and height of around 32 microns, the distance from the signal transmission line (13) to the left and right middle ground layers (12) is around 200 microns and the relative dielectric constant of the filing medium (15) is around 3.4.

5. The connecting structure as claimed in one of the preceding Claims 1 to 4, **characterized in that** the said RF strip-line (1) is connected to the said RF circuits by means of a FPC connector (7) mounted on the PCB (4).

6. The connecting structure as claimed in one of the preceding Claims 1 to 5, **characterized in that** the said RF strip-line (1) is connected to the antenna (2) through a matching components of the antenna (3).

7. The connecting structure as claimed in Claim 6, **characterized in that** the said matching component of the antenna (3) is a thin-film inductor or capacitor.

8. The connecting structure as claimed in Claim 6, **characterized in that** the said matching component of the antenna (3) is on the FPC board.
